# EUROPEAN PATENT APPLICATION

(11) **EP 4 509 918 A1**
(43) Date of publication of application: **19.02.2025**
(21) Application number: 22936720.6
(22) Date of filing: 19.10.2022
(51) Int. Cl.: G03F 1/00, G03F 1/68, G02F 1/01

(54) **MASK, PHOTOLITHOGRAPHIC DEVICE, MANUFACTURING METHOD FOR MASK, AND MASK-BASED PHOTOLITHOGRAPHY METHOD**

(30) Priority: 11.04.2022 CN 202210373932
(71) Applicant: Westlake University, Hangzhou, Zhejiang 310024 (CN)
(72) Inventor: LI, Xijun, Hangzhou, Zhejiang 310024 (CN)
(74) Representative: Meissner Bolte Partnerschaft mbB
(86) International application number: PCT/CN2022/126146
(87) International publication number: WO 2023/197553

(57) **Abstract**

A mask, a lithographing apparatus, a method of manufacturing a mask and a lithographing method based on a mask. The mask includes: a substrate (110) configured to be transmissive to an exposure beam (920) for lithography, wherein the exposure beam (920) is in a first frequency band; and a photochromic layer (120) provided on one side of the substrate (110) and comprising a photochromic material, the photochromic layer being configured to generate a corresponding mask pattern under illumination of a modulation beam (930) with a spatial structure, wherein the photochromic material is in a non-light-transmitting state or a light-transmitting state to the exposure beam based on whether the photochromic material is illuminated by modulation light in the modulation beam (930), and the modulation beam (930)is in a second frequency band separated from the first frequency band.

## Description

### CROSS-REFERENCE TO RELATED APPLICATIONS

The present application claims the priority to the Chinese Patent Application No. 202210373932.5 entitled "MASK, LITHOGRAPHING APPARATUS, METHOD OF MANUFACTURING MASK AND LITHOGRAPHING METHOD BASED ON MASK" filed on April 11, 2022, the disclosure of which is incorporated by reference herein in its entirety.

### TECHNICAL FIELD

The present disclosure generally relates to the technical field of lithography, and more particularly, to a mask, a lithographing apparatus, a method of manufacturing a mask, and a lithographing method based on a mask.

### BACKGROUND

In the lithography technology, a patterned structure is typically formed using a mask. However, once the mask is prepared, the pattern thereon is not easy to be altered. Moreover, if a defect is present in the mask or introduced during the process of the use of the mask, it is difficult to repair the defect. In addition, the mask typically has a high cost. These above factors all can lead to an increase in the cost of the chip produced using the mask, and the complicated process due to monitoring of the mask defect. Therefore, there is a need for a new mask in the chip production technology.

### SUMMARY

An objective of the present disclosure is to provide a mask, a lithographing apparatus, a method of manufacturing a mask, and a lithographing method based on a mask.

According to a first aspect of the present disclosure, there is provided a mask, comprising: a substrate configured to be transmissive to an exposure beam for lithography, wherein the exposure beam is in a first frequency band; and a photochromic layer provided on one side of the substrate and comprising a photochromic material, the photochromic layer being configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

In some embodiments, the substrate comprises at least one of quartz or calcium fluoride.

In some embodiments, the photochromic material is configured to be in the non-light-transmitting state to the exposure beam when illuminated by the modulation light in the modulation beam; and the photochromic material is configured to be in the light-transmitting state to the exposure beam when not illuminated by the modulation light in the modulation beam.

In some embodiments, the photochromic material is configured to be in the light-transmitting state to the exposure beam when illuminated by the modulation light in the modulation beam; and the photochromic material is configured to be in the non-light-transmitting state to the exposure beam when not illuminated by the modulation light in the modulation beam.

In some embodiments, when the photochromic material is in the light-transmitting state, transmittance to the exposure beam is 60%~99%.

In some embodiments, when the photochromic material is in the non-light-transmitting state, transmittance to the exposure beam is 5%~30%.

In some embodiments, a wavelength corresponding to the first frequency band comprises 193~405 nm.

In some embodiments, a wavelength corresponding to the first frequency band comprises at least one of 193 nm, 248 nm, 325 nm, 365 nm, or 405 nm.

In some embodiments, a wavelength corresponding to the second frequency band comprises 500~580 nm, or 580~1100 nm, or a part of 500~580 nm, or a part of 580~1100 nm.

In some embodiments, a wavelength corresponding to the second frequency band comprises 633 nm.

In some embodiments, the photochromic layer comprises a photochromic material in a shape of continuous film.

In some embodiments, a thickness of the photochromic layer is 50~200 nm or 200~5000 nm.

In some embodiments, the photochromic material comprises at least one of an organic photochromic material or an inorganic photochromic material.

In some embodiments, the photochromic material comprises 1,2-bis(5,5'-dimethyl-2,2'-bithiophen-yl)perfluorocyclopent-1-ene.

In some embodiments, the mask further comprises: a modulation light source configured to generate a modulation beam with a spatial structure.

In some embodiments, the modulation light source comprises: a first optical generator configured to generate an initial beam in a second frequency band, the initial beam having a uniform light intensity distribution on a section perpendicular to its travelling direction; and a spatial optical modulator configured to convert the initial beam into the modulation beam with the spatial structure under the action of a control signal, wherein the control signal is generated based on a mask pattern.

In some embodiments, the modulation beam is a near-field beam relative to the photochromic layer.

In some embodiments, the mask further comprises: a temperature controller comprising a temperature maintaining unit configured to be provided adjacent to the mask or the photochromic layer, to maintain a temperature of the mask within a preset temperature range.

According to a second aspect of the present disclosure, there is provided a lithographing apparatus, comprising: the mask as described above; and a control module configured to generate a control signal according to a design layout, the control signal being used for generating a modulation beam with a spatial structure corresponding to the design layout.

In some embodiments, the lithographing apparatus further comprises: a modulation light source configured to generate the modulation beam with the spatial structure.

In some embodiments, the modulation light source comprises: a first optical generator configured to generate an initial beam in a second frequency band, the initial beam having a uniform light intensity distribution on a section perpendicular to its travelling direction; and a spatial optical modulator configured to convert the initial beam into the modulation beam with the spatial structure under the action of a control signal, wherein the control signal is generated according to a mask pattern.

In some embodiments, the lithographing apparatus further comprises: a temperature controller comprising a temperature maintaining unit configured to be provided adjacent to the mask or the photochromic layer, to maintain a temperature of the mask within a preset temperature range.

In some embodiments, the lithographing apparatus further comprises: a second optical generator configured to generate an exposure beam in a first frequency band.

In some embodiments, the exposure beam has a uniform light intensity distribution on a section perpendicular to its travelling direction.

According to a third aspect of the present disclosure, there is provided a method of manufacturing a mask, comprising: providing a substrate, the substrate configured to be transmissive to an exposure beam for lithography, wherein the exposure beam is in a first frequency band; and forming a photochromic layer on one side of the substrate, the photochromic layer comprising a photochromic material and configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

According to a fourth aspect of the present disclosure, there is provided a lithographing method based on a mask that is the mask as described above, comprising: making a modulation beam with a spatial structure illuminate on the mask, to generate a corresponding mask pattern on the mask; after generating the mask pattern, making the exposure beam illuminate on a wafer via the mask, to expose the wafer; after exposing the wafer, turning off the exposure beam; and after turning off the exposure beam, turning off the modulation beam.

In some embodiments, an intensity of the modulation beam is greater than that of the exposure beam.

In some embodiments, the lithographing method further comprises: operating a temperature controller to maintain a temperature of the mask within a present temperature range.

### BRIEF DESCRIPTION OF THE DRAWINGS

The accompanying drawings, which constitute a part of this specification, illustrate the embodiments of the present disclosure and serve to explain the principle of the present disclosure together with the description.

The present disclosure may be more clearly understood from the following detailed description taken in conjunction with the accompanying drawings, in which:
Fig. 1 is a structural schematic diagram of the mask according to an exemplary embodiment of the present disclosure;
Fig. 2 is a schematic diagram of the mask illuminated by the exposure beam and the modulation beam according to an exemplary embodiment of the present disclosure;
Fig. 3 is a schematic sectional diagram of the mask illuminated by the exposure beam and the modulation beam according to an exemplary embodiment of the present disclosure;
Fig. 4 is a structural schematic diagram of the lithographing apparatus according to an exemplary embodiment of the present disclosure;
Fig. 5 is a flow schematic diagram of the method of manufacturing the mask according to an exemplary embodiment of the present disclosure;
Fig. 6 is a flow schematic diagram of the lithographing method based on the mask according to an exemplary embodiment of the present disclosure.

### DETAILED DESCRIPTION

The present disclosure will be described below with reference to the accompanying drawings, which illustrate several embodiments of the present disclosure. However, it should be understood that the present disclosure may be presented in many different ways and is not limited to the embodiments described below; and actually, the embodiments described below are intended to make the disclosure of the present disclosure more complete, and to fully convey the scope of protection of the present disclosure to those skilled in the art. It should also be understood that the embodiments disclosed herein can be combined in various ways so that more additional embodiments are provided.

It should be understood that in all the drawings, identical reference numerals denote identical elements. In the drawings, the size of a certain feature may be deformed for clarity.

It should be understood that the terminology in the description is only used for describing a specific embodiment, and is not intended to limit the present disclosure. All terminologies (including technical and scientific terminologies) used in the description have meanings commonly understood by those skilled in the art, unless otherwise defined. A well-known function or structure may not be described in detail for brevity and/or clarity.

The terminologies "comprise", "include", and "contain" used in the description indicate the presence of the stated feature, but do not exclude the presence of one or more other features. The terminology "and/or" used in the description includes any and all combinations of one or more of associated listed items. The terminologies "between X and Y" and "between about X and Y" used in this description should be construed to include X and Y. The terminology "between about X and Y" used in this description means "between about X and about Y", and the terminology "from about X to Y" used in this description means "from about X to about Y".

In the description, when it is stated that an element is "on", "attached" to, "connected" to, "coupled" to, or "contacted" with another element, etc., the element can be directly on, attached to, connected to, coupled to, or contacted with the other element, or an intermediate element may be present. In contrast, when it is stated that an element is "directly on", "directly attached" to, "directly connected" to, "directly coupled" to, or "directly contacted" with another element, no intermediate element will be present. In the description, a feature being arranged to be "adjacent" to another feature may refer to the feature having a portion overlapped with or located above or below the adjacent feature.

In the description, spatial relation terminologies such as "above", "below", "left", "right", "front", "rear", "high", and "low" may describe the relation between one feature and another feature in the accompanying drawings. It should be understood that the spatial relation terminology encompasses different orientations of an equipment in use or operation in addition to the orientation shown in the drawings. For example, when the equipment in the drawings is inverted, the feature originally described to be "below" another feature may be described to be "above" the other feature at this time. The equipment may also be otherwise oriented (rotated 90 degrees or in another orientation), and at this time, the relative spatial relation may be interpreted accordingly.

In the research of the micro-nano device and the production process of the semiconductor chip, the desired device or chip structure is formed typically using the lithography technology based on the mask. In order to form the desired structure, according to the layout of the device or the chip to be processed, one or more masks may be fabricated in advance in the light of corresponding process procedures, wherein the pattern on each mask may correspond to one layer in the layout or to a plurality of layers that can be prepared in a same procedure. Typically, the mask may include the substrate (e.g., quartz glass) which can cause the exposure beam (e.g., ultraviolet light, etc.) for changing the property of the resist (photoresist) to transmit through, and the plated film (e.g., the metal chromium film) that is deposited on the substrate for preventing the exposure beam descirbed above from transmitting through.

In the method of manufacturing the mask, the chromium film with a thickness of several tens of nanometers and the resist positioned on the chromium film may be sequentially deposited on the quartz glass, then the desired pattern may be formed on the resist by means of laser direct writing or electron beam exposure, and then the chromium exposed from the resist may be wet-etched or dry-etched to form the pattern corresponding to the desired structure on the chromium film. The means of laser direct writing is typically used for forming the mask with the minimum linewidth of above 300 nm, and the means of electron beam exposure can be used for forming the mask with the minimum linewidth of less than 300 nm.

Using the above preparation method, the cost of a single sheet of mask is approximately tens of thousands of dollars, and the cost of a complete set of masks for the complete device or chip production process might be up to millions of dollars. Moreover, once such a mask is prepared, its structure is difficult to be altered. In a traditional application scenario, the amount of a single batch of chips, including a central processing unit (CPU), a dynamic random access memory (DRAM), a flash memory and the like, is typically in the order of millions or even hundreds of millions, so that the cost of fabricating the mask can be well shared, and thus, the lithography process based on the mask can be widely applied to the fabrication and production of these devices or chips. However, with the development of industries such as Internet of Things, artificial intelligence, and personalized life health, production of a small-batch of devices or chips is increasingly involved, and the number of these devices or chips might only be tens of thousands or even less. If the mask is prepared in advance and then these devices or chips are produced based on the mask, it is difficult to share the cost of fabricating the mask by a sufficient number of devices or chips, resulting in a great increase in the device or chip cost. In addition, if these devices or chips are directly fabricated by means of laser direct writing, on one hand, the yield is too low to meet the requirement of mass production, and on the other hand, the minimum linewidth of about 300 nm of the laser direct writing also restricts an increase in the integration and performance of the chips and a decrease in the cost of the chips by means of scaling down the devices. Similarly, if these devices or chips are fabricated directly by means of electron beam exposure, although devices or chips with a smaller size and higher integration can be fabricated, their yield is still too low to satisfy the production requirements, and the processing cost is very high, so that market penetration of the devices and chips is hindered.

In addition, the defect present in the mask might also result in a great increase in the cost of producing the devices or chips. Specifically, if a minor defect is present in the mask, time needs to be spent on detection and repair of the defect; and if a major defect is present in the mask, the entire mask might have to be discarded.

In order to solve the above problems and meet the requirements of production of small-batch chips and development of related products to high integration, so that the future technologies such as Internet of things and artificial intelligence can have better social permeability, the present disclosure provides a programmable, rewritable and reusable digital lithography mask. In such a mask, the light-transmitting state of a corresponding pixel region in the mask can be reversibly changed by controlling a modulation beam with a spatial structure to illuminate on the mask with the photochromic material, such that the pattern on the same mask can be changed as required, thereby realizing reuse of the mask and further reducing the production cost of the devices or chips.

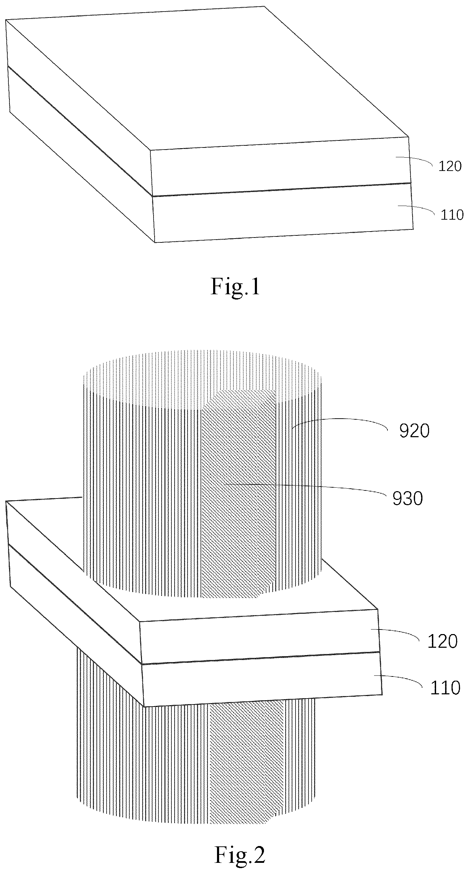

In an exemplary embodiment of the present disclosure, as shown in Fig. 1, the mask may include the substrate 110 and the photochromic layer 120.

The substrate 110 may be configured to be transmissive to the exposure beam for lithography to avoid impeding the lithographing process. The exposure beam may be in the first frequency band, which typically corresponds to the frequency band where partial ultraviolet light is located. For example, the wavelength corresponding to the first band may include 193~405 nm. In some specific examples, the wavelength corresponding to the first band may include at least one of 193 nm, 248 nm, 325 nm, 365 nm, or 405 nm. The substrate 110 may be made of the material with a certain structural strength for supporting other layers of the mask provided thereon. In some embodiments, the substrate 110 may be made of quartz glass, calcium fluoride glass, or the like.

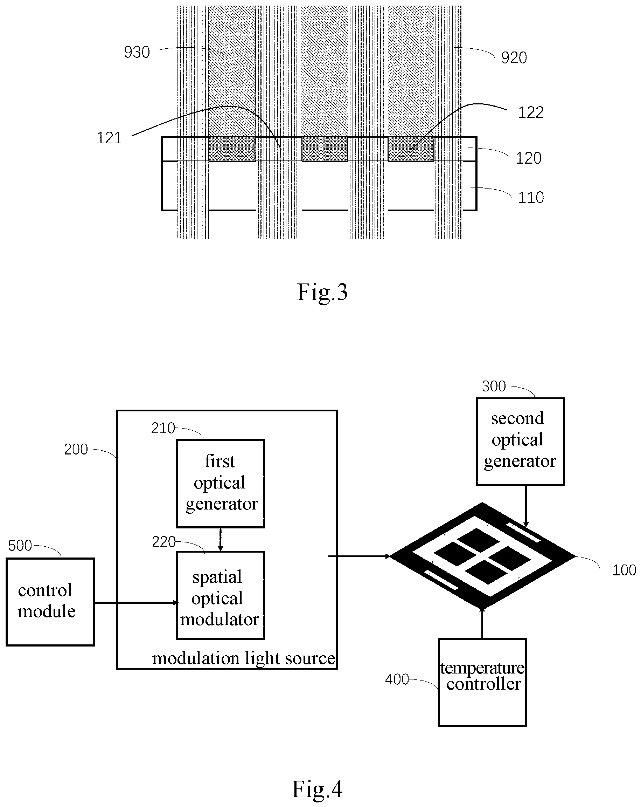

The photochromic layer 120 may be provided on one side of the substrate 110, and the photochromic layer 120 may include a photochromic material and generate a corresponding mask pattern under illumination of the modulation beam with the spatial structure. As shown in Figs. 2 and 3, the modulation beam 930 with the spatial structure specifically refers to the beam having the non-uniform intensity distribution on the section perpendicular to its travelling direction. For example, in the section perpendicular to the travelling direction of the modulation beam 930, the modulation light intensity of partial region may be zero, while another region may have a non-zero modulation light intensity. The photochromic material will be in a non-light-transmitting state or a light-transmitting state to the exposure beam based on whether it is illuminated by modulation light in the modulation beam, to form accordingly the non-light-transmitting region and the light-transmitting region in the mask, thereby generating a desired mask pattern.

In a specific example, when the photochromic material is opposite to the region on the section of the modulation beam 930 that has the non-zero modulation light intensity, i.e., the photochromic material is illuminated by the modulation light in the modulation beam 930, this part of photochromic material will absorb the modulation light and be in the non-light-transmitting state to the exposure beam (for example, the organic photochromic material absorbs the modulation light as the deexcitation light and generates a high absorption rate to the ultraviolet light as the exposure beam, resulting in that this part of organic photochromic material is in the non-light-transmitting state to the exposure beam), corresponding to the non-transmissive region 122 to the exposure beam 920 of the photochromic material shown in Fig. 3; and when the photochromic material is opposite to the region on the section of the modulation beam 930 that has the modulation light intensity of zero, i.e., the photochromic material is not illuminated by the modulation light in the modulation beam 930, this part of photochromic material will be in the light-transmitting state to the exposure beam, corresponding to the light-transmitting region 121 to the exposure beam 920 of the photochromic material shown in Fig. 3. Therefore, by controlling the intensity spatial distribution of the modulation beam, or by controlling the spatial structure of the modulation beam, the light-transmitting region 121 and the non-light-transmitting region 122 to the exposure beam 920 can be formed in the photochromic layer 120, and the combination of these regions can form the desired mask pattern in the mask.

Of course, it can be understood that, in some other specific examples, when the photochromic material is opposite to the region on the section of the modulation beam that has the non-zero modulation light intensity, i.e. when the photochromic material is illuminated by the modulation light in the modulation beam, this part of photochromic material may be in the light-transmitting state to the exposure beam; and when the photochromic material is opposite to the region on the section of the modulation beam that has the modulation light intensity of zero, i.e., the photochromic material is not illuminated by the modulation light in the modulation beam, this part of photochromic material can be in the non-light-transmitting state to the exposure beam.

Furthermore, in general, the non-light-transmitting state (or light-transmitting state) of the photochromic material may be maintained only when the modulation light illuminates on the photochromic material, and once the modulation light is removed, the photochromic material will recover to its default state. Therefore, when lithography is performed using a mask including such photochromic material, it is necessary to keep the modulation beam illuminating on the mask while exposing the wafer/sample using the exposure beam, to maintain the light-transmitting and non-light-transmitting regions in the mask unchanged, or keep the mask pattern unchanged, until the lithography is completed. Because of the above requirements, it is necessary to avoid the interference of the modulation beam 930 to the exposure process, i.e., the modulation beam 930 cannot cause the change in the property of the resist (for example, photoresist), which requires that the modulation beam 930 is in the second frequency band separated from the first frequency band for the exposure beam 920. Here, the separated first and second frequency bands refer to that any frequency in the first frequency band is different from that in the second frequency band. In some embodiments, the wavelength corresponding to the second frequency band may include 500~580 nm, or 580~1100 nm, or a part of 500~580 nm, or a part of 580~1100 nm. In a specific example, a wavelength corresponding to the second frequency band may be 633 nm.

In order to ensure that the photochromic material in the mask can, when in the light-transmitting state, cause enough exposure beam to transmit through for exposing the sample, and when in the non-light-transmitting state, be sufficient to block the exposure beam to avoid exposing the wafer/sample, transmittance of the photochromic material in the light-transmitting and non-light-transmitting states should meet a certain requirement. In a specific example, when the photochromic material is in the light-transmitting state, its transmittance to the exposure beam can be 60%~99%; and when the photochromic material is in the non-light-transmitting state, its transmittance to the exposure beam can be 5%~30%.

In some embodiments, the photochromic material can include at least one of an organic photochromic material or an inorganic photochromic material. A common organic photochromic material may include tetracene solution, benzalphenylhydrazines solution, osazones solution, or the like in a liquid state, and 2,3,4,4-tetrachloronaphthalen-1-(4H)-one, spironaphthoxazines type organic material, diarylethene type material, azobenzene derivative, 1,2-bis(5,5'-dimethyl-2,2'-bithiophen-yl)perfluorocyclopent-1-ene, or the like in a solid state, while the inorganic photochromic material may include a various of transition metal oxides and composites thereof, such as wolfram oxide (WOₓ), molybdenum trioxide (MoO₃), vanadium pentoxide (V₂O₅), and titanium dioxide (TiO₂).

However, it is considered that in current lithographic applications in general cases, the photochromic material that can be used should have at least the following properties: (1) the light-transmitting state and the non-light-transmitting state of the photochromic material can be reversibly switched under the control of the modulation beam, to realize the rewritable and reusable mask, that is, in the case of not being illuminated by the modulation light in the modulation beam, the photochromic material has a sufficiently high transmittance to the exposure beam in the first frequency band, and in the case of being illuminated by the modulation light in the modulation beam, it has a sufficiently low transmittance to the exposure beam in the first frequency band; alternatively, in the case of not being illuminated by the modulation light in the modulation beam, it has a sufficiently low transmittance to the exposure beam in the first frequency band, and in the case of being illuminated by the modulation light in the modulation beam, it has a sufficiently high transmittance to the exposure beam in the first frequency band; and (2) the second frequency band where the modulation beam for reversibly switching the light-transmitting state and the non-light-transmitting state of the photochromic material is located is separated from the first frequency band where the exposure beam (ultraviolet light) is located, to avoid interference to the lithographing process. In view of the above considerations, in the existing process of lithographing using the ultraviolet light as the exposure beam, 1,2-bis(5,5'-dimethyl-2,2'-bithiophen-yl)perfluorocyclopent-1-ene may be used as the photochromic material in the mask. However, it can be understood that when the exposure beam or modulation beam in another frequency band is used, another photochromic material corresponding to the corresponding frequency band may be selected, which is not limited herein. Further, a photochromic material with good heat dissipation and low required modulation beam intensity can be selected to reduce a great increase in the mask temperature due to the illumination of the modulation beam, thereby improving reliability of the lithography.

In general, the photochromic layer 120 may include the photochromic material in a shape of continuous film, to facilitate the preparation of the mask by means of deposition such as lamination, spin coating, and spraying. In order to enable the photochromic material to effectively block the exposure beam when in the non-light-transmitting state, the thickness of the photochromic layer 120 may be 50~200 nm or 200-5000 nm. In some other cases, a patterned photochromic layer may be formed as needed, and the above patterned photochromic layer may be formed by means of laser direct writing, electron beam direct writing, and lithographing based on another mask, or the like. Alternatively, in some other cases, the photochromic material in a liquid state may be used as needed, and at this time, a blocking layer may be further provided above the photochromic layer 120, so that the liquid photochromic material is limited between the substrate 110 and the blocking layer, to maintain the stable property of the structure of the mask, thereby ensuring the exposure effect.

In some embodiments, as shown in Fig.4, a modulation light source 200 may be further included, and the modulation light source 200 may be regarded as a part of the mask, or provided, independently of the mask, in the lithographing apparatus including the mask. The modulation light source 200 may be configured to generate the modulation beam with the spatial structure. Specifically, the modulation light source 200 may include a first optical generator 210 and a spatial optical modulator 220, wherein the first optical generator 210 may be configured to generate an initial beam in the second frequency band, the initial beam having a uniform light intensity distribution on the section perpendicular to its travelling direction; and the spatial optical modulator 220 may be configured to convert the initial beam into the modulation beam with the spatial structure under the action of the control signal generated according to the mask pattern. The spatial structure of the modulation beam corresponds to the desired mask pattern, to form corresponding light-transmitting and non-light-transmitting regions by the modulation beam illuminating on the photochromic material on the mask. In a specific example, the spatial optical modulator may be an optical phase modulator.

In a specific example, the spatial optical modulator may achieve pixels with the number of 4160x2464 and the pixel period of 3.74 µm. Using such a spatial optical modulator, a pattern with a period of 6~8 µm that is composed of minute optical spots with a size of 3~4 µm may be formed on the mask by using the modulation beam with a wavelength of 633 nm. By using such a mask and combining a fourfold (4x) reduced projection lithography technology, the minimum linewidth which can be processed is 1 µm or so, and the area for a single exposure can be 1×1 cm². In the case of projection exposure, supposing that the time required for a single exposure is 100 ms, it is calculated that the lithographing yield of such a mask can reach 600 cm²/min. For the exposure accuracy of 1 µm, the yield described above is 100 times that of laser direct writing, and thus can meet the lithographing requirement of a next generation of printed circuit boards and chip packaging, etc. In addition, in the case that the wavelength of the modulation beam is 633 nm, the minimum resolution of the pattern that can be generated by the modulation beam is 400 nm or so, and by combining the fourfold reduced projection lithography technology and using the exposure beam of 248 nm, the lithographing linewidth of about 100 nm can be achieved, which can meet the lithographing requirement of many subsequent processes of the chip. If it is desired to further improve the linewidth accuracy of the mask while improving the yield, a spatial optical modulator of 10000x10000 or more pixels can be developed. In addition, although the mask in the present disclosure might be limited by the diffraction effect of the modulation beam, the minimum linewidth on the mask is typically 400 nm or so, but by combining higher-fold reduced projection lithography, such as a tenfold (10x) reduced projection lithography technology, and performing exposure using a deep ultraviolet (DUV) exposure beam of 193 nm, for example, the minimum linewidth for the lithographing can be further improved to below 45 nm to meet the production requirement of advanced chips.

Furthermore, in the lithographing process, in order to increase lithographing precision and to improve the accuracy of the lithographing pattern, the exposure beam generated by the second optical generator 300 may be a near-field beam relative to the mask. Similarly, the modulation beam generated by the modulation light source 200 may also be a near-field beam relative to the photochromic layer in the mask, to avoid an influence on precision that is caused by the optical diffraction effect of a far-field beam and to improve the accuracy of the mask pattern.

In some embodiments, considering that the modulation beam for controlling the light-transmitting state or the non-light-transmitting state of the photochromic material typically has a high optical power, in order to avoid excessively strong light from illuminating on the mask or sample, resulting in a rise of a temperature of the mask or sample, as shown in Fig. 4, a temperature controller 400 may be further included. The temperature controller 400 may be regarded as being included in the mask, or being provided, independently of the mask, in the lithographing apparatus including the mask. The temperature controller 400 may include a temperature maintaining unit, which may be configured to be provided adjacent to the substrate 110 or the photochromic layer 120 to maintain the temperature of the mask within a preset temperature range. The temperature controller may be a liquid cooled temperature controller, a thermoelectric semiconductor temperature controller, etc., which is not limited herein. In general, the light intensity of the exposure beam required in the exposure process is typically 10~10000 mW/cm², while the light intensity of the modulation beam for changing the light-transmitting state of the photochromic material is typically required to be within a range of 10~10000 W/cm². For example, in the lithographing process, the light intensity of the modulation beam with the wavelength of 633 nm might be more than 1000 times that of the exposure beam with the wavelength of 325 nm. By maintaining the mask within the preset temperature range using the temperature controller 400, the mask can be prevented from being damaged under the action of the strong modulation beam, and it can be even realized that the photochromic material in the mask is excited using a modulation beam with higher intensity (e.g. 100 kW/cm²), to rapidly change the light-transmitting state of the photochromic material and obtain the desired transmittance as ideal as possible.

In the mask of the present disclosure, the reversible change in the light-transmitting state of individual pixel region can be controlled using the photochromic material therein. In this way, a corresponding mask pattern can be directly formed based on a data file of the required structure of the device or chip, and the mask pattern on the same mask can be erased and rewritten, which achieves reuse of the mask, improves the utilization efficiency of the mask, reduces the cost of fabricating the device or chip, and avoids a series of problems caused by overhigh mask cost in traditional lithography.

In an exemplary embodiment of the present disclosure, a lithographing apparatus is also provided. As shown in Fig. 4, the lithographing apparatus may include a body 100 of the mask as described above and a control module 500. In some embodiments, the lithographing apparatus may further include at least one of the modulation light source 200 as described above, a second optical generator 300 configured to generate the exposure beam in the first frequency band (the exposure beam typically has a uniform light intensity distribution on the section perpendicular to its travelling direction, or has a uniform light intensity distribution at least in the central region of the section), or the temperature controller 400 as described above. The control module 500 may be configured to generate, according to the layout, the control signal, for generating the modulation beam with the spatial structure corresponding to the layout. Specifically, the control module 500 may be configured to generate a plurality of mask patterns corresponding to one or more layers in the layout of the device or chip, and generate a corresponding control signal according to individual mask pattern. Further, the control module 500 may transmit the control signal to the spatial optical modulator 220, so that the spatial optical modulator 220 changes the light-transmitting state of individual pixel region in the mask.

In the lithographing apparatus of the embodiments of the present disclosure, a corresponding reversible mask can be directly manufactured using the data file of the pattern to be exposed; by combining the 10x reduced projection and LELE (Litho-Etch-Litho-Etch) technology and the like, the lithographing apparatus can meet the production requirement of small-batch chips of 14 nm or even more advanced process nodes. The fabrication of complex devices or chips can be efficiently and accurately completed through only one or a few reusable and rewritable masks, which reduces the cost of fabricating the devices or chips, and facilitates rapid updating, mass production and better market penetration of the devices or chips.

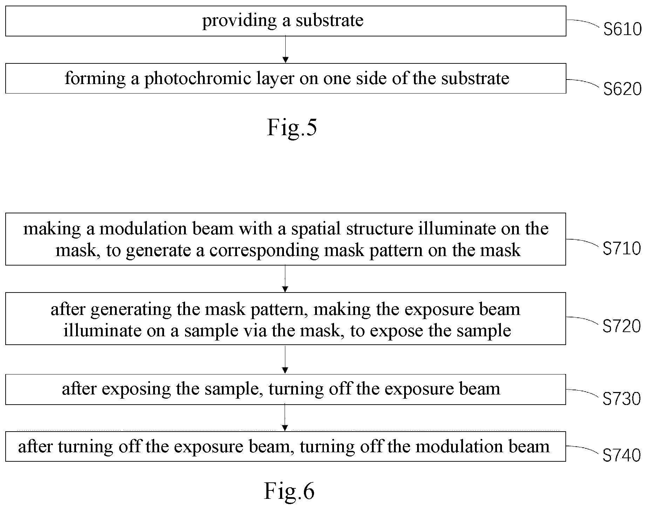

In an exemplary embodiment of the present disclosure, there is also provided a method of manufacturing a mask, which may include, as shown in Fig. 5:
step S610, providing a substrate;
step S620, forming a photochromic layer on the substrate,
wherein, the substrate may be configured to be transmissive to the exposure beam for lithography, wherein the exposure beam is in the first frequency band, the photochromic layer may include the photochromic material and configured to generate a corresponding mask pattern under illumination of the modulation beam with the spatial structure, wherein the photochromic material is in the non-light-transmitting state or the light-transmitting state to the exposure beam based on whether the photochromic material is illuminated by modulation light in the modulation beam, and the modulation beam is in the second frequency band separated from the first frequency band.

In an exemplary embodiment of the present disclosure, there is also provided a lithographing method based on the mask as described above, which may include, as shown in Fig. 6:
step S710, making a modulation beam with a spatial structure illuminate on the mask, to generate a corresponding mask pattern on the mask;
step S720, after generating the mask pattern, making the exposure beam illuminate on a wafer/sample coated with the photoresist, via the mask, to expose the wafer;
step S730, after exposing the wafer/sample, turning off the exposure beam; and
step S740, after turning off the exposure beam, turning off the modulation beam.

In other words, the modulation beam should be kept in the on state in the whole exposure process, to guarantee correctness of the mask pattern. The intensity of the modulation beam may be greater than that of the exposure beam. Correspondingly, the lithographing method may further include: operating a temperature controller to maintain a temperature of the mask within a present temperature range.

Although exemplary embodiments of the present disclosure have been described, those skilled in the art should appreciate that numerous variations and modifications may be made to the exemplary embodiments of the present disclosure without essentially departing from the spirit and scope of the present disclosure. Therefore, all the variations and modifications are included within the scope of protection of the present disclosure that is defined in the claims. The present disclosure is defined by the appended claims, and equivalents of these claims are also included therein.

## Claims

1. A mask, comprising:
a substrate configured to be transmissive to an exposure beam for lithography, wherein the exposure beam is in a first frequency band; and
a photochromic layer provided on one side of the substrate and comprising a photochromic material, the photochromic layer being configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

2. The mask according to claim 1, wherein the substrate comprises at least one of quartz or calcium fluoride.

3. The mask according to claim 1, wherein the photochromic material is configured to be in the non-light-transmitting state to the exposure beam when illuminated by the modulation light in the modulation beam; and
the photochromic material is configured to be in the light-transmitting state to the exposure beam when not illuminated by the modulation light in the modulation beam.

4. The mask according to claim 1, wherein the photochromic material is configured to be in the light-transmitting state to the exposure beam when illuminated by the modulation light in the modulation beam; and
the photochromic material is configured to be in the non-light-transmitting state to the exposure beam when not illuminated by the modulation light in the modulation beam.

5. The mask according to claim 1, wherein when the photochromic material is in the light-transmitting state, transmittance to the exposure beam is 60%~99%.

6. The mask according to claim 1, wherein when the photochromic material is in the non-light-transmitting state, transmittance to the exposure beam is 5%~30%.

7. The mask according to claim 1, wherein a wavelength corresponding to the first frequency band comprises 193~405 nm.

8. The mask according to claim 1, wherein a wavelength corresponding to the first frequency band comprises at least one of 193 nm, 248 nm, 325 nm, 365 nm, or 405 nm.

9. The mask according to claim 1, wherein a wavelength corresponding to the second frequency band comprises 500~580 nm, or 580~1100 nm, or a part of 500~580 nm, or a part of 580~1100 nm.

10. The mask according to claim 1, wherein a wavelength corresponding to the second frequency band comprises 633 nm.

11. The mask according to claim 1, wherein the photochromic layer comprises a photochromic material in a shape of continuous film.

12. The mask according to claim 1, wherein a thickness of the photochromic layer is 50~200 nm or 200~5000 nm.

13. The mask according to claim 1, wherein the photochromic material comprises at least one of an organic photochromic material or an inorganic photochromic material.

14. The mask according to claim 1, wherein the photochromic material comprises 1,2-bis(5,5'-dimethyl-2,2'-bithiophen-yl)perfluorocyclopent-1-ene.

15. The mask according to claim 1, wherein the mask further comprises:
a modulation light source configured to generate a modulation beam with a spatial structure.

16. The mask according to claim 15, wherein the modulation light source comprises:
a first optical generator configured to generate an initial beam in a second frequency band, the initial beam having a uniform light intensity distribution on a section perpendicular to its travelling direction; and
a spatial optical modulator configured to convert the initial beam into the modulation beam with the spatial structure under the action of a control signal, wherein the control signal is generated based on a mask pattern.

17. The mask according to claim 1, wherein the modulation beam is a near-field beam relative to the photochromic layer.

18. The mask according to claim 1, further comprising:
a temperature controller comprising a temperature maintaining unit configured to be provided adjacent to the mask or the photochromic layer, to maintain a temperature of the mask within a preset temperature range.

19. A lithographing apparatus comprising:
the mask according to any of claims 1 to 14; and
a control module configured to generate a control signal according to a layout, the control signal being used for generating a modulation beam with a spatial structure corresponding to the layout.

20. The lithographing apparatus according to claim 19, further comprising:
a modulation light source configured to generate the modulation beam with the spatial structure.

21. The lithographing apparatus according to claim 20, wherein the modulation light source comprises:
a first optical generator configured to generate an initial beam in a second frequency band, the initial beam having a uniform light intensity distribution on a section perpendicular to its travelling direction; and
a spatial optical modulator configured to convert the initial beam into the modulation beam with the spatial structure under the action of a control signal, wherein the control signal is generated according to a mask pattern.

22. The lithographing apparatus according to claim 19, further comprising:
a temperature controller comprising a temperature maintaining unit configured to be provided adjacent to the mask or the photochromic layer, to maintain a temperature of the mask within a preset temperature range.

23. The lithographing apparatus according to claim 19, further comprising:
a second optical generator configured to generate an exposure beam in a first frequency band.

24. The lithographing apparatus according to claim 23, wherein the exposure beam has a uniform light intensity distribution on a section perpendicular to its travelling direction.

25. A lithographing apparatus comprising:
the mask according to any of claims 15 to 18; and
a control module configured to generate a control signal according to a layout, the control signal being used for generating a modulation beam with a spatial structure corresponding to the layout.

26. A method of manufacturing a mask, comprising:
providing a substrate, the substrate configured to be transmissive to an exposure beam for lithography, wherein the exposure beam is in a first frequency band; and
forming a photochromic layer on one side of the substrate, the photochromic layer comprising a photochromic material and configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

27. A lithographing method based on a mask that is the mask according to any of claims 1 to 18, comprising:
making a modulation beam with a spatial structure illuminate on the mask, to generate a corresponding mask pattern on the mask;
after generating the mask pattern, making the exposure beam illuminate on a sample via the mask, to expose the sample;
after exposing the sample, turning off the exposure beam; and
after turning off the exposure beam, turning off the modulation beam.

28. The lithographing method according to claim 27, wherein an intensity of the modulation beam is greater than that of the exposure beam.

29. The lithographing method according to claim 27, further comprising:
operating a temperature controller to maintain a temperature of the mask within a present temperature range.
